(19) Europäisches Patentamt
European Patent Office
Office européen des brevets

(11) Veröffentlichungsnummer: **0 265 375 B1**

(12) **EUROPÄISCHE PATENTSCHRIFT**

(45) Veröffentlichungstag der Patentschrift: **03.06.92**

(51) Int. Cl.5: **G03F 7/004**

(21) Anmeldenummer: **87810556.8**

(22) Anmeldetag: **25.09.87**

# (54) Photoresist-Zusammensetzungen.

(30) Priorität: **01.10.86 CH 3918/86**

(43) Veröffentlichungstag der Anmeldung:
**27.04.88 Patentblatt 88/17**

(45) Bekanntmachung des Hinweises auf die Patenterteilung:
**03.06.92 Patentblatt 92/23**

(84) Benannte Vertragsstaaten:
**CH DE FR GB IT LI NL**

(56) Entgegenhaltungen:
**GB-A- 1 317 796**
**US-A- 3 531 414**

(73) Patentinhaber: **CIBA-GEIGY AG**
**Klybeckstrasse 141**
**CH-4002 Basel(CH)**

(72) Erfinder: **Bauer, Sigrid, Dr.**
**35, chemin de la Grangette**
**CH-1094 Paudex(CH)**

EP 0 265 375 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft positiv arbeitende Photoresist-Zusammensetzungenenthaltend eine lichtempfindliche Verbindung in einem filmbildenden polymeren Bindemittel und als Entwicklungsbeschleuniger ein Bis-benztriazol, ein Verfahren zur Erzeugung von positiven Abbildungen, sowie die Verwendung dieser Bis-benztriazole als Entwicklungsbeschleuniger in Positiv-Photoresists.

Die Halbleiterindustrie verlangt heute Kopierlacke, welche sich nicht nur durch grosse Empfindlichkeit auszeichnen, sondern auch gegen höhere Temperaturen beständig sind. Um eine Massenherstellung zu gewährleisten, muss der Zeitaufwand der Herstellung möglichst niedrig gehalten werden. Bisherige Systeme haben den Nachteil, dass die Zusammensetzungen entweder schlechter zu entwickeln sind oder zur Verbesserung der Entwickelbarkeit länger belichtet werden mussen.

Es sind bereits Versuche unternommen worden, die Entwicklung durch den Zusatz von chemischen Verbindungen zu beschleunigen. In der US-PS 3,661,582 sind aromatische heterocyclische Verbindungen, darunter z.B. Benztriazol, als Entwicklungshilfsmittel beschrieben. In der US-PS 4,365,019 wird beschrieben, dass Benztriazole, welche im Benzteil zwei bis vier Halogenatome tragen, besonders vorteilhaft in positiv arbeitenden Photoresist-Zusammensetzungen verwendet werden können.

Die vorliegende Erfindung betrifft positiv arbeitende Photoresist-Zusammensetzungen, enthaltend eine lichtempfindliche Verbindung in einem filmbildenden polymeren Bindemittel und mindestens eine Verbindung der Formel I

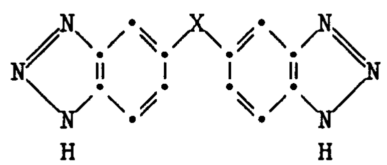

(I),

worin X $-C_nH_{2n}-$, -O-, -S- oder -C(O)- bedeutet, wobei n eine Zahl von 1 bis 6 ist.

Die Verbindungen der Formel I sind bekannt, und z.B. in der US-PS 3,531,414 beschrieben. Sie können nach den dort beschriebenen Methoden hergestellt werden und wurden bisher als Korrosionsschutzmittel bei der Metalloberflächenbehandlung eingesetzt.

Besonders bevorzugt werden Verbindungen der Formel I eingesetzt, worin X $-C_nH_{2n}-$ und insbesondere $-CH_2-$ bedeutet.

Erwähnenswert ist auch die Verbindung der Formel I worin X -S- ist.

Bei der erfindungsgemässen Verwendung treten trotz des relativ hohen Molekulargewichts keine Verträglichkeitsprobleme auf. Die erfindungsgemäss einzusetzenden Bis-benztriazole sind bekannten Verbindungen bezüglich Schmelzpunkt, Flüchtigkeit und/oder Löslichkeit überlegen und lassen sich breit anwenden. Wie in Beispiel 2 gezeigt, ist auch durch "zweistufige Belichtung" eine Bildumkehr möglich, womit ein komplementäres Bild der Positivvorlage erhalten wird.

Photoresist-Zusammensetzungen sind in zahlreichen Veröffentlichungen beschrieben worden, z.B. in DeForest, "Photoresist Materials and Processes", McGraw-Hill Book Company, N.Y., 1975. Diese umfassen aus einer Lösung hergestellte Ueberzüge oder als Trockenfilm aufgetragene Ueberzüge. Der positiv arbeitende Resist wird nach Belichtung durch aktivierende Strahlung im Entwickler löslich.

Die positiv arbeitenden Photoresists bestehen im wesentlichen aus einer lichtempfindlichen Verbindung in einem filmbildenden polymeren Bindemittel. Es kann sich dabei um physikalische Mischungen oder um Umsetzungsprodukte, sogenannte Diazoharze handeln. Die am häufigsten verwendeten lichtempfindlichen Verbindungen oder Sensibilisatoren sind als Chinondiazide bekannt geworden. Es handelt sich dabei vor allem um Ester und Amide von o-Chinondiazid-carbonsäuren und insbesondere -sulfonsäuren. Geeignete Sensibilisatoren dieser Art sind beispielsweise beschrieben in DeForest (a.a.O., s.S. 47-55) und den folgenden US-PSen: 2,754,209; 3,046,110; 3,046,112;3,046,113; 3,046,116; 3,046,118; 3,046,119, 3,046,120; 3,647,443; 3,759,711 oder 4,141,733. Bevorzugt handelt es sich dabei um Naphthochinondiazide, und insbesondere um o-Naphthochinon(4- oder 5-)sulfonsäure-Derivate. Dabei werden die monomeren Chinondiazid-sulfonsäuren in Form ihrer Ester oder Amide in das Bind emittel eingearbeitet oder man lässt z.B. ein Chinondiazid-sulfonsäurechlorid mit dem Bindemittel reagieren, wie es etwa in der US-PS 4,141,733 oder der GB-PS 1,546,633 beschrieben ist. Letztere werden Diazoharze genannt.

Die Wahl des Bindemittels erfolgt je nach Anwendungsgebiet und den hierfür geforderten Eigenschaften. Eine Zusammenstellung möglicher Harze findet sich bei DeForest (a.a.O., S. 57-59).

Besonders geeignete Bindemittel sind beispielsweise Novolake, die sich von einem Aldehyd, vorzugsweise Acetaldehyd oder Formaldehyd, insbesondere jedoch von Formaldehyd, und einem Phenol ableiten. Die phenolische Komponente dieser Bindemittel ist vorzugsweise Phenol selbst, oder auch halogeniertes Phenol, beispielsweise substituiert mit ein bis zwei Chloratomen, vorzugsweise p-Chlorphenol, oder sie ist ein durch ein bis zwei $C_1$-$C_9$-Alkylgruppen substituiertes Phenol, beispielsweise o-, m- oder p-Kresol, ein Xylenol, p-tert.Butylphenol oder p-Nonylphenol. Es kann sich bei der Phenolkomponente der bevorzugten Novolake aber auch um p-Phenylphenol, Resorcin, Bis-(4-hydroxyphenyl)-methan oder 2,2-Bis-(4-hydroxyphenyl)-propan handeln.

Ein Teil der phenolischen Hydroxygruppen dieser Novolake kann gegebenenfalls durch Umsetzung mit Chloressigsäure, Isocyanaten, Epoxiden oder Carbonsuaureanhydriden modifiziert sein.

Weitere geeignete Bindemittel sind beispielsweise Polyvinylphenole oder Copolymere von Maleinsäureanhydrid mit Styrol oder Vinylethern oder 1-Alkenen, bzw. Copolymere von Hydroxy- oder Aminostyrol mit Styrol, Vinylacetat usw.

Ebenfalls als Bindemittel einsetzen lassen sich Copolymere von Estern der Acrylsäure oder Methacrylsäure mit ethylenisch ungesättigten Säuren, beispielsweise Methacrylsäure oder Acrylsäure.

Mit dem Ausdruck Diazoharz werden Bindemittel bezeichnet, welche lichtempfindliche Chinondiazid-Substituenten tragen. Es handelt sich also nicht um physikalische Gemische aus lichtunempfindlichen Bindemitteln und lichtempfindlichen Verbindungen, sondern um lichtempfindliche Bindemittel, welche durch Umsetzung eines lichtunempfindlichen Bindemittels mit einer lichtempfindlichen Verbindung, insbesondere einem reaktionsfähigen Chinondiazids, z.B. einem o-Naphthochinondiazid-sulfochlorid erhalten werden können. Solche Diazoharze sind z.B. in der US-PS 3,046,120; der US-PS 4,141,733, GB-PS 1,026,144, GB-PS 1,113,759; DE-PS 18 03 712, DE-PS 19 11 497 oder der CA-PS 903,545 beschrieben und können nach den dort beschriebenen Methoden hergestellt werden.

Besonders geeignet für die Umsetzung mit einem lichtempfindlichen reaktionsfähigen Chinondiazid, z.B. mit o-Naphthochinondiazid-(4-oder 5-)sulfochlorid sind Phenol- oder Kresolformaldehydharze, Polyvinylphenole oder Amino- bzw. Hydroxystyrol-Copolymere z.B. mit Styrol, Vinylacetat u.ä.

Den alkalilöslichen Bindemitteln bzw. Azoharzen können gegebenenfalls noch weitere Zusatzharze beigegeben werden, wie es bei den Positiv-Systemen üblich ist. Zu diesen Zusatzharzen zählen beispielsweise Vinylpolymerisate, wie Polyvinylacetat, Polyacrylate, Poly-(methacrylsäurealkylester) oder Poly-(acrylsäure/alkylester), wobei mit Alkyl $C_1$-$C_{20}$-Alkyl gemeint ist, Polyvinylether oder Polyvinylpyrrolidone. Im allgemeinen werden jedoch nicht mehr als 20 Gew.-%, bezogen auf die Menge an alkalilöslichem Bindemittel, von diesen Zusatzharzen zugefügt.

In der Regel werden beispielsweise 1-15 Gew.-% des Entwicklungsbeschleunigers bezogen auf den Gesamtfeststoff eingesetzt, insbesondere 2-10 Gew.-%.

Die erfindungsgemässen Zusammensetzungen können weitere übliche Zusatzstoffe enthalten, wie z.B. Stabilisatoren, Pigmente, Farbstoffe, Füllstoffe, Haftvermittler, Verlaufmittel, Netzmittel und Weichmacher. Ferner können die Zusammensetzungen zur Applikation in geeigneten Lösungsmitteln gelöst werden.

Die erfindungsgemässen Zusammensetzungen eignen sich hervorragend als Beschichtungsmittel für Substrate aller Art , z.B. Holz, Textilien, Papier, Keramik, Glas, Kunststoffe, wie Polyester, Polyethylenterephthalat, Polyolefine oder Celluloseacetat, insbesondere in Form von Filmen, sowie von Metallen, wie Al, Cu, Ni, Fe, Zn, Mg oder Co, und von Si oder $SiO_2$, bei denen durch bildmässiges Belichten eine Abbildung aufgebracht werden soll. Ein weiterer Gegenstand vorliegender Erfindung sind die beschichteten Substrate.

Die Erfindung betrifft ferner auch ein Verfahren zur Erzeugung von positiven Abbildungen, umfassend folgende Arbeitsschritte:

a) Beschichtung eines Substrates mit einer strahlungsempfindlichen Zusammensetzung wie oben definiert,

b) Belichtung des beschichteten Substrates mit einem vorbestimmten Muster aktinischer Strahlung, und

c) Entwicklung des belichteten Substrates.

Die Herstellung der beschichteten Substrate kann z.B. erfolgen, indem man eine Lösung oder Suspension der Zusammensetzung herstellt. Die Wahl des Lösungsmittels und die Konzentration richtet sich hauptsächlich nach der Art der Zusammensetzung und nach dem Beschichtungsverfahren. Die Lösung wird mittels bekannten Beschichtungsverfahren auf ein Substrat gleichförmig aufgebracht, z.B. durch Schleudern, Tauchen, Rakelbeschichtung, Vorhanggiessverfahren, Aufpinseln, Sprühen und Reverse Rollbeschichtung. Es ist auch möglich, die lichtempfindliche Schicht auf einen temporären, flexiblen Träger zu bringen, und dann durch Schichtübertragung via Lamination das endgültige Substrat, z.B. eine kupferkaschierte Leiterplatte, zu beschichten.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in weit variablen Schichtdicken eingesetzt werden können.

Mögliche Einsatzgebiete der erfindungsgemässen Zusammensetzungen sind die Verwendung als Photoresists für die Elektronik (Galvanoresist, Aetzresist), die Herstellung von Druckplatten, wie Offsetdruckplatten für den autotypischen Tiefdruck oder für den Rollodruck und ferner für die Herstellung von Siebdruckformen, der Einsatz beim Formteilätzen oder der Einsatz als Mikroresist bei der Herstellung integrierter Schaltkreise.

Dementsprechend unterschiedlich sind die möglichen Schichtträger und die Verarbeitungsbedingungen der beschichteten Substrate.

Für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate.

Nach Beschichten wird das Lösungsmittel in der Regel durch Trocknen entfernt und es resultiert eine Schicht des Photoresist auf dem Träger.

Nach der in üblicher Weise erfolgten bildmässigen Belichtung des Materials werden die belichteten Stellen des Photolackes durch Herauslösen in einem Entwickler entfernt.

Besonders bevorzugt als Entwickler werden wässrig alkalische Lösungen, wie sie für die Entwicklung von Naphthochinondiazidschichten eingesetzt werden. Dazu zählen insbesondere wässrige Lösungen von Alkalimetallsilikaten, -phosphaten und -hydroxiden oder Trialkylammoniumverbindungen. Diese Lösungen können gegebenenfalls noch kleinere Mengen an Netzmitteln und/oder organischen Lösungsmitteln zugesetzt sein.

Typische organische Lösungsmittel, sind solche, die mit Wasser mischbar sind und den Entwicklerflüssigkeiten zugesetzt werden können, wie beispielsweise 2-Ethoxyethanol oder Aceton, sowie Mischungen zweier oder mehrerer solcher Lösungsmittel.

Der Begriff 'Belichtung mit einem vorbestimmten Muster aktinischer Strahlung' beinhaltet sowohl die Belichtung durch eine Photomaske, die ein vorbestimmtes Muster enthält, beispielsweise ein Diapositiv, sowie die Belichtung durch einen Laserstrahl, der beispielsweise computergesteuert über die Oberfläche des beschichteten Substrates bewegt wird, und auf diese Weise ein Bild erzeugt.

Die Lichtempfindlichkeit der erfindungsgemässen Zusammensetzungen reicht in der Regel vom UV-Gebiet (ca. 250 nm) bis ca. 600 nm und umspannt somit einen sehr breiten Bereich. Als Lichtquellen kommen daher eine grosse Anzahl der verschiedensten Typen zur Anwendung. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenz lampen, Argonglühlampen, Elektronenblitzlampen und photographische Flutlichtlampen. Der Abstand zwischen Lampen und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Argonionenlaser oder Kryptonionenlaser mit starken Emissionslinien (Ar-Laser) bei 457, 476, 488, 514, 528 nm. Bei dieser Art der Belichtung ist keine Photomaske im Kontakt mit der Photopolymerschicht mehr nötig; der gesteuerte Laser-Strahl schreibt direkt auf die Schicht. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Die Erfindung betrifft daher auch die Verwendung der Zusammensetzungen, wie oben definiert, als Positiv-Photoresists für die Herstellung von positiv arbeitenden Kopierlacken, welche z.B. zur Herstellung von integrierten Schaltungen, Aetzreserven, Offsetdruckplatten, Farbprüffolien, Schablonen, Namensschilder etc. dienen.

Beispiel 1: Es wird eine Beschichtungslösung (I) aus

| | |
|---|---|
| 10,50 Gew.t. | eines Kresol-Formaldehyd-Novolaks mit einem Erweichungspunkt von 110-120 °C, |
| 2,00 Gew.t. | eines Epoxidharzes mit einem Epoxiwert von 2,0-2,2, |
| 1,25 Gew.t. | des Veresterungsproduktes aus 1 Mol 2,3,4-Trihydroxybenzophenon und 2,5 Mol Naphthochinon-(1,2)-diazid-(2)-5-sulfochlorid, |
| 0,09 Gew.t. | Kristallviolett (Colour Index No. 42 555) und |
| 35,60 Gew.t. | eines Lösungsmittelgemisches aus Ethylglykol, Ethyl-glykolacetat und Methylethylketon (im Verhältnis 2:2:1) |

bereitet und mit einem Drahtrakel auf kupferkaschiertes Basismaterial aufgetragen, Trockenschichtdicke: 2 µm.

Es wird ausserdem eine Beschichtungslösung (II) bereitet, bei der einer, entsprechend Lösung (I)

zusammengesetzten Formulierung zusätzlich 0,6 Gew.t. 5,5′-Methylen-bis-benztriazol hinzugefügt wurden. Diese wird ebenfalls mit einen Drahtrakel auf kupferkaschiertes Basismaterial aufgetragen und getrocknet, Trockenschichtdicke: 2 µm.

Die mit den Lösungen (I) und (II) beschichteten Muster werden unter einem 21-stufigen Graukeil der Firma Stauffer mit einer 5 KW Metallhalogenidlampe sechs Sekunden belichtet und mit den nachstehend aufgeführten Entwicklern entwickelt.

Entwickler: A

| | |
|---|---|
| 940,0 Gew.t.: | deion. Wasser |
| 40,0 Gew.t.: | $Na_3PO_4$, wasserfrei |
| 20,0 Gew.t.: | Natrium-meta-silikat x 5 $H_2O$ |

Entwickler: B

| | |
|---|---|
| 1000,0 Gew.t.: | deion. Wasser |
| 50,0 Gew.t.: | Natrium-meta-silikat x 5 $H_2O$ |
| 2,5 Gew.t.: | Natriumhydroxid |

Entwickler: C

"MICROPOSIT®303" Developer der Firma Shipley Co., Inc.

Die nachstehende Tabelle gibt an, welche Zeit für eine saubere Aufentwicklung benötigt und welche (erste) Vollstufe in dieser Zeit erreicht wurde.

| Entwickler \ Beschichtungslösung | I | II |
|---|---|---|
| A | 150" (11) | 60" (11) |
| B | 50" (12) | 25" (12) |
| C/Wasser 1:3 | 25" (13) | 15" (14) |
| 1:5 | 50" (13) | 20" (14) |
| 1:6 | 75" (12) | 30" (14) |

(Volltonstufe, gemessen)

Resultat: Der Zusatz von 5,5′-Methylen-bis-benztriazol verkürzt die Entwicklungszeit erheblich.

Beispiel 2: Eine Beschichtungslösung wird aus

| | |
|---|---|
| 10,50 Gew.t. | eines Kres ol-Formaldehyd-Novolaks mit einem Erweichungspunkt von 110-120 °C, |
| 0,50 Gew.t. | eines Epoxidharzes mit einem Epoxiwert von 2,0-2,2, |
| 1,50 Gew.t. | eines Copolymeren aus Methylmethacrylat/Methacrylsäure (75:25) |
| 1,25 Gew.t. | des Veresterungsproduktes aus 1 Mol 2,2′,4,4′-Tetrahydroxy-benzophenon und 2 Mol Naphthochinon-(1,2)-diazid-(2)-5-sulfochlorid, |
| 0,30 Gew.t. | 5,5′-Methylen-bis-benztriazol, |
| 0,09 Gew.t. | Kristallviolett (Colour Index No. 42 555) und |
| 35,60 Gew.t. | eines Lösungsmittelgemisches aus Aethylglykol, Aethylglykolacetat und Methylethylketon (2:2:1) |

bereitet und mit einem Drahtrakel auf 0,1 mm starkes Aluminiumblech aufgetragen und getrocknet. Danach wird unter einer photographischen Positivvorlage 6 Sekunden mit einer Metallhalogenidlampe belichtet, anschliessend 5 Minuten bei 120 °C nachgetrocknet.

Zum Zweck einer "Bildumkehr" wird die Schicht nun 10 Sekunden vollflächig belichtet und danach mit dem in Beispiel 1 mit A bezeichneten Entwickler, mit Wasser 1:1 verdünnt, entwickelt.

Auf der unter einer Positivvorlage belichteten Positivschicht ist ein komplementäres Bild der Positivvorlage abgebildet.

Beispiel 3: Es wird eine Beschichtungslösung (III) aus

| | |
|---|---|
| 6,00 Gew.t. | eines Veresterungsproduktes aus einem Kresol-Formaldehyd-Novolak mit Naphthochinon-(1,2)-diazid-(2)-5-sulfochlorid, Stickstoffgehalt ~1,5 %, |
| 14,00 Gew.t. | 1-Methoxy-2-propanol und |
| 0,04 Gew.t. | Kristallviolett (Colour Index No. 42 555) |

bereitet und auf 0,1 mm starkes Aluminiumblech aufgetragen und getrocknet.

Im Vergleich dazu wird eine Beschichtungslösung (IV) aus einer entsprechenden Beschichtungslösung (III) und Zugabe von 0,3 Gew.t. 5,5′-Methylen-bis-benztriazol bereitet und ebenso auf ein Aluminiumblech mit einem Drahtrakel aufgetragen und getrocknet.

Die Muster werden entsprechend Beispiel 1 belichtet, mit dem in Beispiel 1 beschriebenen Entwickler A sowie mit dem

Entwickler: D

"MICROPOSIT®MF 314" Developer der Firma Shipley Co., Inc.
und dem

Entwickler: E

unter dem Handelnamen KODAK micro positive developer® 809 der Eastman Kodak Company bekannt, entwickelt.

Die nachstehende Tabelle gibt an, welche Zeit für eine saubere Aufentwicklung benötigt und welche (erste) Volltonstufe in dieser Zeit erreicht wurde.

| Entwickler \ Beschichtungslösung | III | IV |
|---|---|---|
| A | 45" (7) | 20" (7) |
| A/Wasser: 1:1 | 3' NE | 100" (6) |
| D | 60" (7) | 30" (7) |
| E/Wasser 1:1 | 120" (6) | 45" (8) |
| 1:2 | 3' NE | 120" (7) |

*) NE: bei angegebener Zeit nicht entwickelt

Beispiel 4: Es wird eine Beschichtungslösung (V) aus

| | |
|---|---|
| 6,00 Gew.t. | eines Veresterungsproduktes aus einem Kresol-Formaldehyd-Novolak mit Naphthochinon-(1,2)-diazid-(2)-5-sulfochlorid, Stickstoffgehalt 1,6 %, |
| 1,50 Gew.t. | eines Styrol/Maleinsäureanhydrid-Copolymeren, Handelsnamen Scripset® 550, |
| 0,04 Gew.t. | Kristallviolett (Colour Index No. 42 555) und |
| 16,30 Gew.t. | 1-Methoxy-2-propanol |

bereitet und auf blankes Aluminiumblech aufgetragen und getrocknet.

Im Vergleich dazu wird eine Beschichtungslösung (VI) aus einer entsprechenden Beschichtungslösung (V) und Zugabe von 0,3 Gew.t. 5,5′-Methylen-bis-benztriazol bereitet und ebenfalls auf ein Aluminiumblech mit einem Drahtrakel aufgetragen und getrocknet.

Die Muster werden 12 Sekunden mit einer 5 KW Metallhalogenidlampe unter einem Graukeil belichtet und mit dem in Beispiel 1 beschriebenen Entwickler A sowie den in Beispiel 3 erwähnten Ent wicklern D und E im Schaukelbad entwickelt. Die Platten werden mit einem Wattebausch leicht überwischt, mit Wasser abgespült und anschliessend getrocknet.

| Entwickler \ Beschichtungslösung | V | VI |
|---|---|---|
| A | 120" (9) | 60" (9) |
| A/Wasser: 1:1 | 180" (S) | 180" (8) |
| D | 60" (8) | 30" (8) |
| E/Wasser 1:1 | 150" (10) | 90" (10) |
| 1:2 | 180" (S) | 180" (9) |
| 1:3 | 180" (S) | 180" (8) |

Die obenstehende Tabelle gibt an, welche Zeit für eine saubere Aufentwicklung benötigt und welche (erste) Volltonstufe in dieser Zeit erreicht wurde.

(S) bedeutet Schleier, der trotz Ueberwischen nicht entfernt werden konnte.

## Patentansprüche

1. Positiv arbeitende Photoresist-Zusammensetzungen enthaltend eine lichtempfindliche Verbindung in einem filmbildenden polymeren Bindemittel und mindestens eine Verbindung der Formel (I)

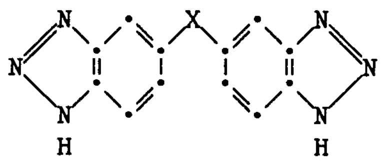

(I),

worin X $-C_nH_{2n}-$, -O-, -S- oder -C(O)- bedeutet, wobei n eine Zahl von 1 bis 6 ist.

2. Zusammensetzungen gemäss Anspruch 1, wobei in der Formel (I) X $C_nH_{2n}$ ist.

3. Zusammensetzungen gemäss Anspruch 2, wobei X $CH_2$ ist.

4. Zusammensetzungen gemäss Anspruch 1, wobei in der Formel (I) X S ist.

5. Zusammensetzungen gemäss Anspruch 1, enthaltend als lichtempfindliche Komponente ein Chinondiazid.

6. Verfahren zur Erzeugung positiver Abbildungen umfassend folgende Arbeitsschritte:
   - Beschichten eines Substrats mit einer strahlungsempfindlichen Zusammensetzung gemäss Anspruch 1,
   - Belichten des beschichteten Substrats mit einem vorbestimmten Muster aktinischer Strahlung, und
   - Entwicklung des belichteten Substrates.

7. Verwendung der Zusammensetzungen gemäss Anspruch 1 als positiv arbeitende Kopierlacke.

## Claims

1. A photoresist composition which operates positively and contains a light-sensitive compound in a film-forming polymeric binder and at least one compound of the formula (I)

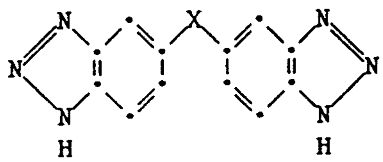

(I),

in which X is $-C_nH_{2n}-$, -O-, -S- or -C(O)-, n being a number from 1 to 6.

**2.** A composition according to claim 1, in which X in the formula (I) is $C_nH_{2n}$.

**3.** A composition according to claim 2, in which X is $CH_2$.

**4.** A composition according to claim 1, in which X in the formula (I) is S.

**5.** A composition according to claim 1, which contains a diazoquinone as the light-sensitive component.

**6.** A process for the production of positive images, which comprises the following operational steps:
- coating a substrate with a radiation-sensitive composition according to claim 1,
- exposing the coated substrate to a predetermined pattern of actinic radiation, and
- developing the exposed substrate.

**7.** The use of a composition according to claim 1 as a positively operating copying lacquer.

## Revendications

**1.** Compositions de photorésists (photoréserves) travaillant en positif, compositions qui contiennent un composé photosensible dans un liant polymère filmogène et au moins un composé répondant à la Formule I :

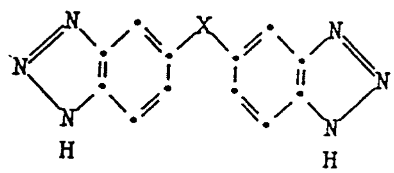

(1)

dans laquelle X représente $-C_nH_{2n}-$, -O-, -S- ou -C(O)-, l'indice n désignant un nombre de 1 à 6.

**2.** Compositions selon la revendication 1 dans lesquelles le symbole X, dans la Formule (I), représente un radical $C_nH_{2n}$.

**3.** Compositions selon la revendication 2 dans lesquelles X représente un radical $CH_2$.

**4.** Compositions selon la revendication 1 dans lesquelles le symbole X, dans la Formule (I), représente S.

**5.** Compositions selon la revendication 1 qui contiennent, comme composante photosensible, un quinonediazide.

**6.** Procédé pour créer des images positives qui comprend les étapes opératoires suivantes :
- revêtement d'un substrat avec une composition photosensible selon la revendication 1,.
- exposition du substrat revêtu à un rayonnement actinique conformément à un modèle donné et
- développement du substrat exposé.

**7.** Application des compositions selon la revendication 1 comme laques à copier travaillant en positif.